# EUROPÄISCHE PATENTSCHRIFT

(11) **EP 2 503 612 B1**
(45) Veröffentlichungstag und Bekanntmachung des Hinweises auf die Patenterteilung: **29.04.2020**
(21) Anmeldenummer: 12160122.3
(22) Anmeldetag: 19.03.2012
(51) Int. Cl.: H01L 43/06, H01L 43/14, G01R 33/07

(54) **Vertikaler Hallsensor und Verfahren zur Herstellung eines vertikalen Hallsensors**
Vertical hall sensor and method of making a vertical hall sensor
Capteur Hall vertical et procédé de fabrication d'un capteur Hall vertical

(30) Priorität: 24.03.2011 CH 5312011
(43) Veröffentlichungstag der Anmeldung: 26.09.2012
(73) Patentinhaber: Melexis Technologies NV, 3980 Tessenderlo (BE); X-FAB Semiconductor Foundries AG, 99097 Erfurt (DE)
(72) Erfinder: Schott, Christian, 1167 Lussy-sur-Morges (CH); Hofmann, Peter, 01454 Radeberg (DE)
(74) Vertreter: Falk, Urs

(56) Entgegenhaltungen:
- EP-A1- 2 234 185
- EP-A2- 2 192 417
- DE-A1-102005 014 157
- DE-A1-102005 051 306
- DE-A1-102006 017 910
- US-A- 5 627 398

## Beschreibung

Die Erfindung betrifft einen vertikalen Hallsensor, der in einen Halbleiterchip integriert ist, und ein Verfahren zur Herstellung eines solchen vertikalen Hallsensors.

Ein vertikaler Hallsensor ist ein Magnetfeldsensor, der empfindlich ist auf ein Magnetfeld, das parallel zur Oberfläche des Halbleiterchips verläuft. Der vertikale Hallsensor besteht in der Regel aus einer n-dotierten Wanne, die in ein p-dotiertes Substrat eindiffundiert wurde, oder einer p-dotierten Wanne, die in ein n-dotiertes Substrat eindiffundiert wurde, wobei die Wanne typischerweise vier oder fünf Kontakte aufweist, die entlang einer Geraden angeordnet sind und sich an der Oberfläche des Halbleiterchips befinden. Zwei oder drei der vier Kontakte sind Stromkontakte, die dazu dienen, einen Strom durch den vertikalen Hallsensor fliessen zu lassen, und zwei der anderen Kontakte sind Spannungskontakte, die dazu dienen, die Hallspannung abzugreifen, die bei einem Magnetfeld entsteht, das senkrecht zur Richtung des Stromes verläuft.

Die am häufigsten verwendeten vertikalen Hallsensoren weisen vier Kontakte oder fünf Kontakte oder allenfalls sechs Kontakte auf und sind aus der Literatur, z.B. aus der Thesis Nr. 3134 der Ecole Polytechnique Fédérale de Lausanne von Enrico Schurig, wie auch aus der Patentliteratur, z.B. aus US 5572058, EP 1540748, DE 102005014157, DE 102006061883, WO 2010101823, hinreichend bekannt. Ein vertikaler Hallsensor mit mehr als sechs Kontakten ist bekannt aus EP 2192417.

Eine der schwierigsten Aufgaben bei der Entwicklung der vertikalen Hallsensoren besteht seit jeher darin, einerseits eine hohe Magnetfeldempfindlichkeit zu erzielen und andererseits den sogenannten Offset des Sensorsignals, das ist die bei Abwesenheit eines Magnetfeldes zwischen den Spannungskontakten anliegende Spannung, möglichst gering zu halten.

Wegen der technologiebedingt auf wenige Mikrometer begrenzten Tiefe der Wanne müssen die Kontakte möglichst nahe beieinander liegen, um eine hohe Empfindlichkeit zu erreichen. Da herkömmliche, durch Ionenimplantation und nachfolgende relativ lange Diffusion erzeugte Wannen jedoch die höchste Dotierung an der Oberfläche aufweisen, fliesst der Hauptanteil des Stromes durch das Hallelement natürlicherweise ebenfalls dicht unter der Oberfläche und ist damit für die Erzeugung der Hallspannung wenig wirksam, so dass die Empfindlichkeit klein ist. Ausserdem ist der Strompfad zwischen Eingangsstromkontakt und Ausgangsstromkontakt dadurch sehr kurz, was zur Folge hat, dass schon sehr kleine Prozesstoleranzen zu hohem Offset führen.

Aus der EP 1977460 ist ein vertikaler Hallsensor bekannt, bei dem zwischen den Kontakten elektrisch nicht-leitende Gebiete angeordnet sind, welche als Barrieren wirken, die den zwischen den Kontakten fliessenden Strom zwingen, diese Barrieren in der Tiefe zu umfliessen. Sind diese Barrieren jedoch als Gebiete mit umgekehrter Dotierung ausgestaltet, so bilden sich um diese herum ladungsträgerfreie Gebiete, deren Dicke von der jeweils lokal anliegenden Potentialdifferenz zwischen der Barriere und dem umgebenden leitenden Gebiet abhängt. Änderungen dieser Potenzialdifferenz verursachen eine Änderung der Geometrie des leitenden Gebietes. Dies wiederum führt zu Schwankungen des Offsets. Der Offset des Sensors nimmt dann typischerweise mit zunehmender Betriebsspannung wie auch mit zunehmender Umgebungstemperatur zu.

Der Erfindung liegt die Aufgabe zugrunde, einen vertikalen Hallsensor zu entwickeln, dessen Offset möglichst gering und dessen Empfindlichkeit möglichst hoch ist.

Die genannte Aufgabe wird erfindungsgemäss gelöst durch einen Hallsensor mit den Merkmalen des Anspruchs 1 und ein Verfahren mit den Merkmalen des Anspruchs 4. Vorteilhafte Ausgestaltungen ergeben sich aus den abhängigen Ansprüchen.

Die Erfindung wird nachfolgend anhand von Ausführungsbeispielen und anhand der Zeichnung näher erläutert. Die Figuren sind schematisch und nicht massstäblich gezeichnet.
- Fig. 1 und 2: zeigen schematisch in seitlicher Ansicht und in Aufsicht einen vertikalen Hallsensor, der in einen Halbleiterchip integriert ist,
- Fig. 3: zeigt Dotierungsprofile,
- Fig. 4A bis 7B: zeigen schematisch in seitlicher Ansicht und in Aufsicht weitere vertikale Hallsensoren, und
- Fig. 8 bis 10: zeigen Dotierungsprofile.

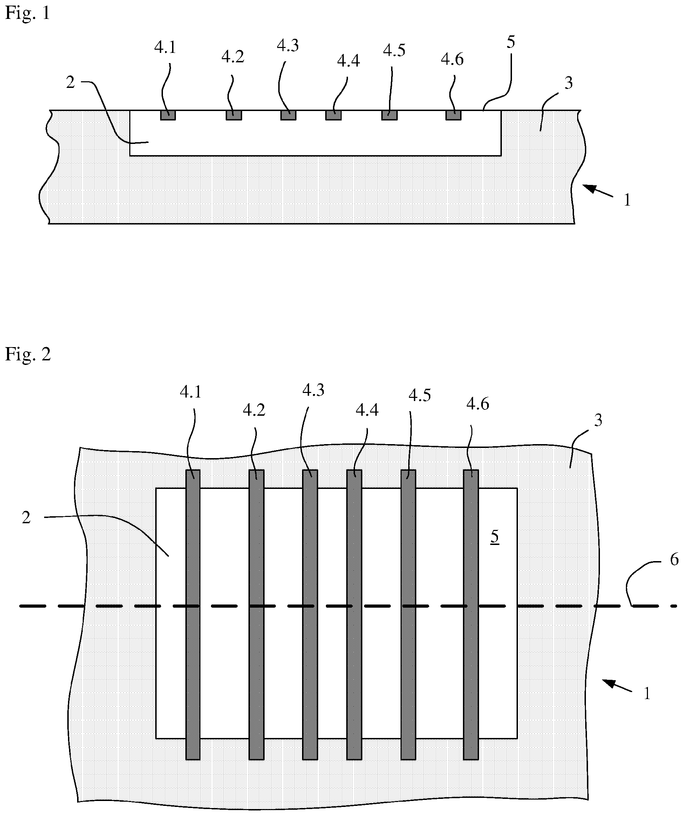

Die Fig. 1 und 2 zeigen schematisch in seitlicher Ansicht und in Aufsicht einen vertikalen Hallsensor, der in einen Halbleiterchip 1 integriert ist. Der vertikale Hallsensor umfasst eine elektrisch leitende Wanne 2 eines ersten Leitfähigkeitstyps, die in ein elektrisch leitendes Gebiet 3 eines zweiten Leitfähigkeitstyps eingebettet ist, und eine Anzahl n von Kontakten 4.1 bis 4.n, die die Wanne 2 kontaktieren. Die Gesamtheit der Kontakte 4.1 bis 4.n wird der Einfachheit halber als Kontakte 4 bezeichnet. Die Kontakte 4 sind in eine Oberfläche 5 der Wanne 2 eingebettet und entlang einer Geraden 6 angeordnet, wobei sich die Oberfläche 5 der Wanne 2 direkt, d.h. nur durch übliche Oxidations- und Passivierungsschichten getrennt, unterhalb der für die Verdrahtung zugänglichen Oberfläche des Halbleiterchips 1 befindet.

Die Wanne 2 besteht vorzugsweise aus n-dotiertem Halbleitermaterial und das Gebiet 3 aus p-dotiertem Halbleitermaterial. Die Wanne 2 ist somit durch einen pn-Übergang elektrisch vom Gebiet 3 isoliert. In dem gezeigten Beispiel beträgt die Anzahl n der Kontakte 4 n=6. Der vertikale Hallsensor kann aber auch n=4, n=5 oder eine noch höhere Anzahl n an Kontakten 4 aufweisen. Die Kontakte 4 können gleiche oder auch unterschiedliche Abstände voneinander haben. Die Kontakte 4 sind hochdotierte Gebiete des ersten Leitfähigkeitstyps, die in der Regel gleich breit sind wie die Wanne 2, jedoch auch etwas breiter oder etwas schmaler sein können. Der Hallsensor ist empfindlich auf ein Magnetfeld, das parallel zur Oberfläche des Halbleiterchips 1 und senkrecht zur Geraden 6 verläuft, und gehört deshalb in die Klasse der vertikalen Hallsensoren. Der Halbleiterchip 1 enthält weiter eine Vielzahl von nicht dargestellten integrierten elektronischen Elementen, die eine elektronische Schaltung für den Betrieb des vertikalen Hallsensors bilden.

Der Begriff der Wanne 2 ist im Rahmen der Beschreibung und der Ansprüche so zu verstehen, dass die Wanne 2 ein durch Ionenimplantation und Aktivierung der implantierten Fremdatome durch Erwärmung erzeugtes Gebiet ist und dass die Wanne 2 nicht durch ein Epitaxieverfahren hergestellt werden kann. Die Wanne 2 wird erfindungsgemäss durch hochenergetische Ionenimplantation hergestellt, um zu erreichen, dass die Leitfähigkeit in der Tiefe mindestens so gross, vorzugsweise grösser, ist wie nahe an der Oberfläche 5. Damit wird erreicht, dass ein Grossteil des Stroms zwischen nicht-benachbarten Stromkontakten auf einem etwa halbkreisförmigen Strompfad um den dazwischen liegenden Spannungskontakt herum fliesst. Das bringt folgende Vorteile mit sich:
a) Die Länge dieses halbkreisförmigen Weges ist analytisch betrachtet π/2 = 1.57 mal länger als die direkte, kürzeste Distanz zwischen den Stromkontakten an der Oberfläche 5. Damit wird der Einfluss von Abstandstoleranzen ebenfalls um diesen Faktor gesenkt und damit eine Reduktion des Offsets erreicht.
b) Die Lorentkraft, die auf die Ladungsträger einwirkt und den Halleffekt bewirkt, ist entlang des gesamten Strompfades genau in Richtung des Spannungskontaktes gerichtet. Die Folge ist eine Erhöhung der Empfindlichkeit.
c) Toleranzen der seitlichen Ränder der Kontakte 4 haben weniger Einfluss, da der Strom bei den Kontakten 4 direkt in die Tiefe fliesst.

Eine Wanne 2, deren elektrische Leitfähigkeit in der Tiefe mindestens so gross, vorzugsweise grösser, ist wie nahe an ihrer Oberfläche 5, ohne dass ein Epitaxieverfahren für ihre Herstellung verwendet wird, kann mittels hochenergetischer Ionenimplantation und anschliessender Erwärmung erzeugt werden, beispielsweise durch folgende Schritte:
A) Implantieren von Fremdatomen eines ersten chemischen Elementes in das elektrisch leitende Gebiet 3 des zweiten Leitfähigkeitstyps mittels einer hochenergetischen Ionenimplantation,
B) fakultativer Schritt, wird später erläutert,
C) fakultativer Schritt, wird später erläutert, und
D) elektrisches Aktivieren der implantierten Fremdatome durch Erwärmung.
In der Silizium basierten Halbleitertechnologie wird üblicherweise das chemische Element Phosphor oder Arsen verwendet, um eine n-leitende Wanne in einem p-leitenden Substrat zu erzeugen, da Phosphoratome und Arsenatome in Silizium n-leitende Fremdatome sind.

Die hochenergetische Ionenimplantation erfolgt vorzugsweise mit einer Energie im Bereich von 1 MeV bis 2.5 MeV oder höher, womit sich eine Tiefe der implantierten Fremdatome von 3 bis 4 Mikrometer erreichen lässt. Die hochenergetische Ionenimplantation erzeugt ein Dotierungsprofil der Fremdatome, das ein Maximum hat, welches sich im Abstand von der besagten Oberfläche 5 befindet. Der Abstand des Maximums des Dotierungsprofils der Fremdatome von der Oberfläche 5 wird hierin als Tiefe T₁ₐ bezeichnet. Es ist T₁ₐ > 0.

Die elektrische Aktivierung erfolgt bevorzugt mittels eines in der Fachwelt als "Annealing" bekannten Prozesses, beispielsweise mittels eines sogenannten "Rapid Thermal Annealing". Ein solches "Annealing" ist eine relativ kurzzeitige Erwärmung, bei der die Fremdatome nicht "weit", in der Regel nur zu einem der nächsten Gitterplätze des Halbleiter-Kristallgitters, diffundieren, so dass das bei der Implantation im Schritt A erzeugte Dotierungsprofil der Fremdatome nicht bzw. nicht wesentlich ändert. Die hochenergetische Ionenimplantation und die relativ kurzzeitige Erwärmung ergeben zusammen ein Dotierungsprofil der Fremdatome, das in der Tiefe T₁ ein Maximum hat, wobei T₁ = T₁ₐ. oder zumindest T₁ ≅ T₁ₐ.

Die Erwärmung kann allerdings auch zeitlich länger bemessen sein, so dass auch eine Diffusion der Fremdatome stattfindet, bei der ein Teil der Fremdatome in Richtung zur besagten Oberfläche 5 der Wanne 2 und ein Teil der Fremdatome in Richtung weg von der besagten Oberfläche 5 der Wanne 2 diffundiert und bewirkt, dass das Maximum der Dotierung verschwindet und die Dotierung bis zu einer Tiefe T₂ mit T₂ > 0 im wesentlichen annähernd konstant ist.

Das resultierende Dotierungsprofil der Wanne 2 zeichnet sich somit dadurch aus, dass entweder mehr Fremdatome in der Tiefe als dicht an der Oberfläche 5 der Wanne 2 in den Halbleiterchip eingebunden sind oder dass die Dotierung der Fremdatome von der Oberfläche 5 bis zu einer gewissen Tiefe im wesentlichen konstant ist.

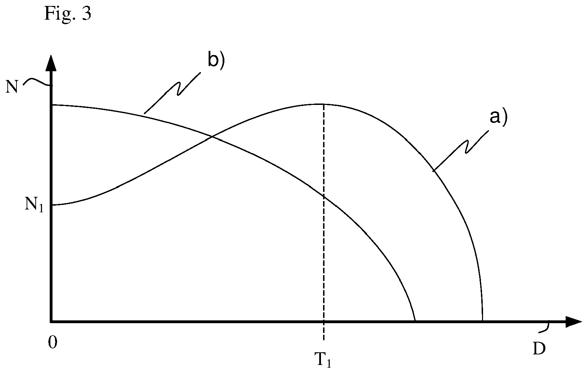

Die Fig. 3 zeigt qualitativ mit der Kurve a das Dotierungsprofil, bzw. die Dotierung N, der Wanne 2 in Funktion der Tiefe D, d.h. des Abstands von der Oberfläche 5 der Wanne 2, eines erfindungsgemässen vertikalen Hallsensors, das durch die hochenergetische Ionenimplantation und ein "Annealing" erzeugt wurde, im Vergleich zur Kurve b des Dotierungsprofils der Wanne eines vertikalen Hallsensors nach dem Stand der Technik. Das Dotierungsprofil der Kurve a verläuft kontinuierlich und enthält keinen abrupten Übergang. Die Dotierung der Fremdatome bei der Oberfläche 5, d.h. bei der Tiefe D = 0, hat einen Wert N₁, der deutlich geringer ist als die Dotierung der Fremdatome beim Maximum.

Die Herstellung des vertikalen Hallsensors wird vorteilhafterweise um den Schritt B und/oder beide Schritte B und C erweitert, die nachfolgend beschrieben sind:
B) Implantieren von Fremdatomen eines zweiten chemischen Elementes in dem von der Wanne 2 belegten Gebiet, um ein Dotierungsprofil der Wanne 2 zu erzeugen, dessen Dotierung und somit dessen elektrische Leitfähigkeit in den Gebieten zwischen den Kontakten 4 in der Nähe der Oberfläche 5 weiter reduziert ist.
C) Implantieren von Fremdatomen des ersten chemischen Elementes (oder eines dritten chemischen Elementes mit dem gleichen Typ Leitfähigkeit wie das erste chemische Element) in den von den Kontakten 4 zu belegenden bzw. belegten Gebieten, um unterhalb der Kontakte 4 ein Dotierungsprofil der Wanne 2 zu erzeugen, das bis zur Tiefe T₁ₐ eine höhere Leitfähigkeit aufweist als das Dotierungsprofil der Wanne 2 zwischen den Kontakten 4.

Das mit den Schritten A und C erzeugte Dotierungsprofil ist in den Gebieten der Kontakte 4 beispielsweise bis zur Tiefe T₁ₐ annähernd konstant. Der Schritt C erfolgt ebenfalls durch Ionenimplantation, wobei die kinetische Energie der Ionen im Schritt C geringer als im Schritt A ist, so dass das Maximum der Dotierung der im Schritt C implantierten Fremdatome in einer Tiefe T₃ₐ liegt, die geringer als die Tiefe T₁ₐ ist.

Die Schritte B und C werden bevorzugt vor dem Schritt D durchgeführt, so dass das Erwärmen, insbesondere das Erwärmen in Form eines "Annealing", für alle Fremdatome gleichzeitig erfolgt.

In der Silizium basierten Halbleitertechnologie ist das zweite chemische Element üblicherweise Bor, da Boratome in Silizium p-leitende Fremdatome sind. Selbstverständlich können auch andere chemische Elemente als die genannten Bor, Phosphor und Arsen verwendet werden, um die gewünschten Dotierungen zu erhalten.

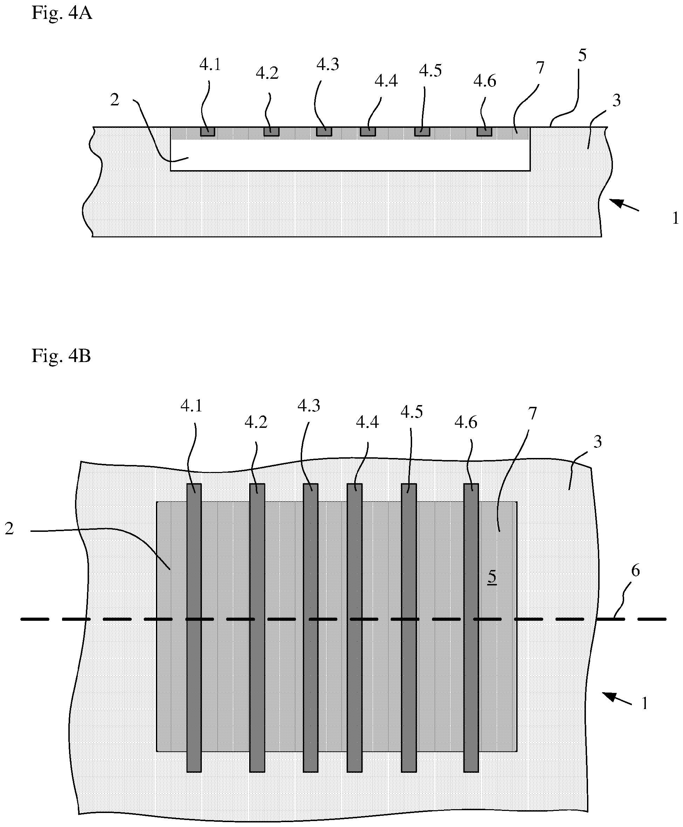

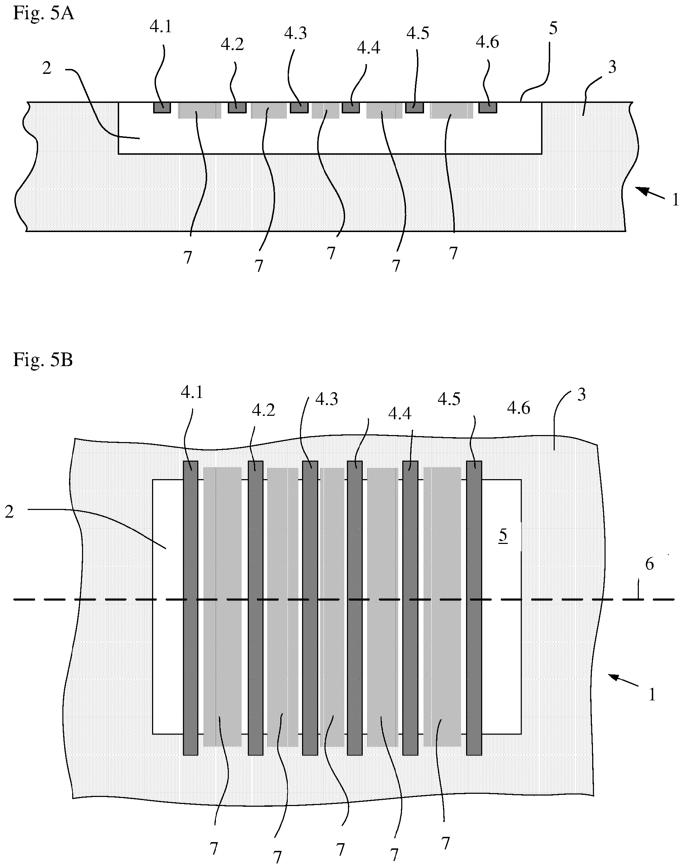

Die Fig. 4A, 4B und 5A, 5B illustrieren zwei alternative Dotierungen der Wanne 2 des vertikalen Hallsensors nach den Schritten A und B. Die Fig. 4A und B illustrieren im Querschnitt bzw. in Aufsicht die erste Alternative, bei der die Implantation der Fremdatome des zweiten chemischen Elementes ohne Verwendung einer Implantationsmaske und damit im gesamten Gebiet der Wanne 2 erfolgte. Die Fig. 5A und B illustrieren im Querschnitt bzw. in Aufsicht die zweite Alternative, bei der die Implantation der Fremdatome des zweiten chemischen Elementes unter Verwendung einer Implantationsmaske nur in denjenigen Gebieten der Wanne 2 erfolgte, die zwischen den Kontakten 4 liegen. Die mit den Fremdatomen des zweiten chemischen Elementes dotierten Gebiete sind mit dem Bezugszeichen 7 bezeichnet.

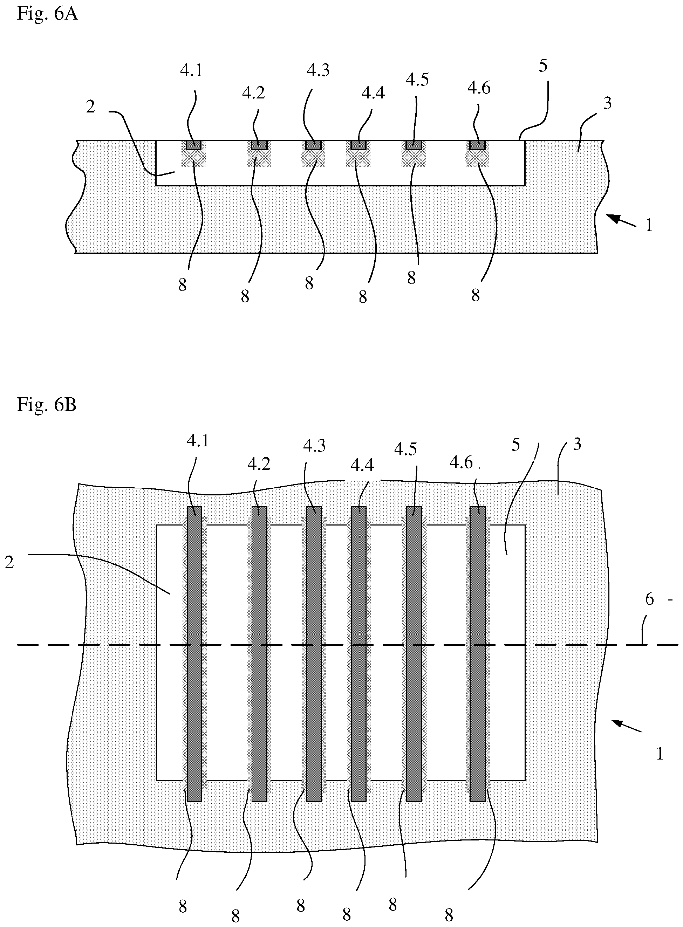

Die Fig. 6A und B zeigen im Querschnitt bzw. in Aufsicht den Dotierungszustand der Wanne 2 nach den Schritten A und C, wobei die Gebiete mit den im Schritt C implantierten Fremdatomen mit dem Bezugszeichen 8 bezeichnet sind.

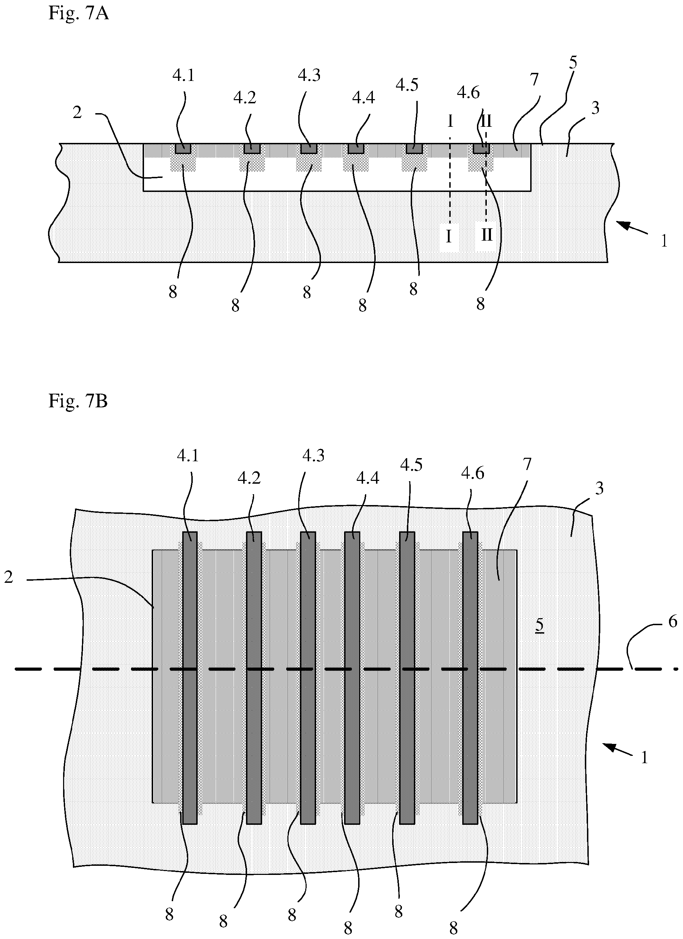

Die Fig. 7A und B zeigen im Querschnitt bzw. in Aufsicht den Dotierungszustand der Wanne 2, wenn alle drei Schritte A, B und C durchgeführt wurden.

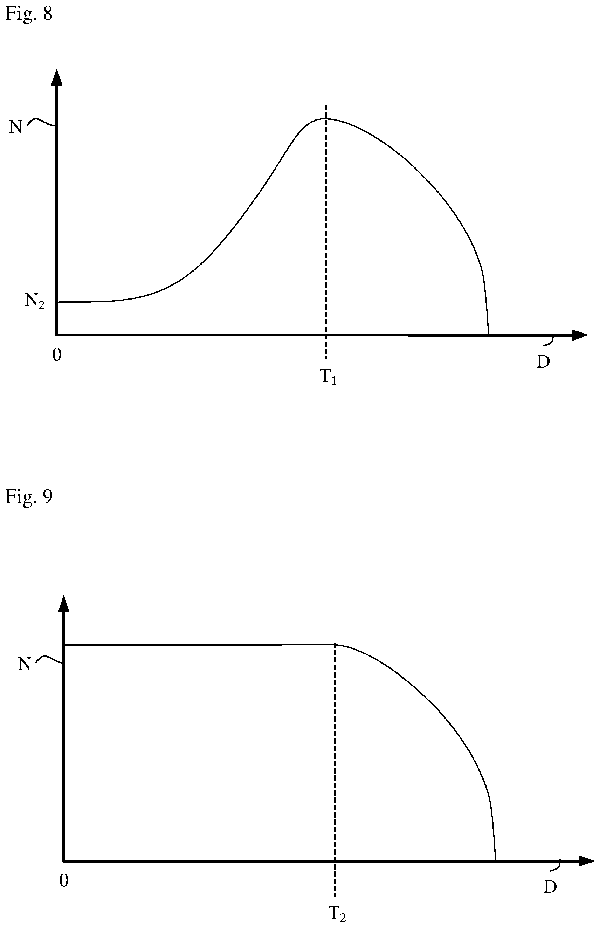

Die Fig. 8 zeigt qualitativ das Dotierungsprofil der Wanne 2 entlang der Linie I-I der Fig. 7A. Die Fig. 9 zeigt qualitativ das Dotierungsprofil der Wanne 2 entlang der Linie II-II der Fig. 7A. Die Dotierung N₂ der Fremdatome bei der Oberfläche 5 der Wanne 2, d.h. bei der Tiefe D = 0, in den Bereichen zwischen den Kontakten 4 ist deutlich kleiner als die Dotierung N₁ des in der Fig. 3 gezeigten Beispiels.

Ein Dotierungsprofil, das bis zu einer vorbestimmten Tiefe T₂ annähernd konstant oder allenfalls wellenförmig und gemittelt über die Wellen annähernd konstant ist, und dann kontinuierlich abnimmt, kann anstelle der im Schritt A beschriebenen hochenergetischen Implantation und relativ langer Diffusion auch mit einem Verfahren erzeugt werden, das die Schritte Schritte A1 und D umfasst:
A1) Implantieren von Fremdatomen eines ersten chemischen Elementes in das elektrisch leitende Gebiet 3 des zweiten Leitfähigkeitstyps mittels Ionenimplantation, bei der die Energie der Ionen entweder in diskreten Schritten oder kontinuierlich von einem Minimalwert zu einem Maximalwert zunehmend erhöht oder von einem Maximalwert zu einem Minimalwert erniedrigt wird, so dass das erzeugte Dotierungsprofil bis zu einer Tiefe T₂ₐ von der planaren Oberfläche 5 der elektrisch leitenden Wanne 2 mehrere Maxima aufweist oder annähernd konstant ist, und
D) elektrisches Aktivieren der implantierten Fremdatome durch Erwärmung.
Der Minimalwert beträgt beispielsweise 1 MeV, der Maximalwert entspricht typischerweise 2.5 MeV oder dem höchstmöglichen Wert, den der verwendete Ionenimplanter ermöglicht.

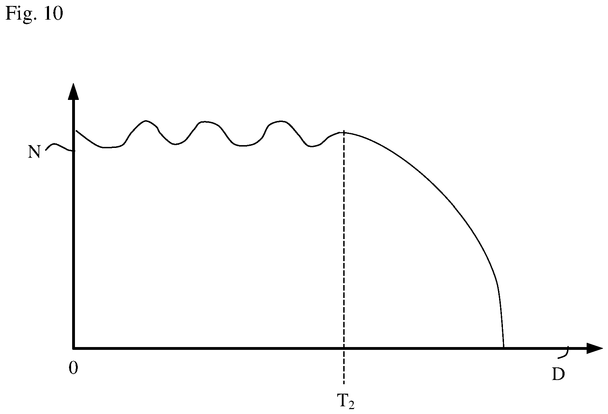

Die Fig. 10 zeigt qualitativ ein gemäss diesem Verfahren erzeugtes Dotierungsprofil der Wanne 2.

## Patentansprüche

1. Vertikaler Hallsensor, der in einen Halbleiterchip (1) integriert ist, mit einer elektrisch leitenden Wanne (2) eines ersten Leitfähigkeitstyps, die in ein elektrisch leitendes Gebiet (3) eines zweiten Leitfähigkeitstyps eingebettet ist, und mit elektrischen Kontakten (4), die dazu dienen, einen Strom durch den vertikalen Hallsensor fliessen zu lassen und eine Hallspannung abzugreifen, und die entlang einer Geraden (6) an einer planaren Oberfläche (5) der elektrisch leitenden Wanne (2) angeordnet sind, die parallel zu einer für die Verdrahtung zugänglichen Oberfläche des Halbleiterchips (1) verläuft, wobei die elektrisch leitende Wanne (2) ein durch Ionenimplantation und nicht durch ein Epitaxieverfahren hergestelltes Dotierungsprofil aufweist und elektrisch seitlich und unten durch einen pn-Übergang vom genannten elektrisch leitenden Gebiet (3) isoliert ist, **dadurch gekennzeichnet, dass** das Dotierungsprofil entweder ein Maximum aufweist, das sich in einer Tiefe T von der planaren Oberfläche (5) der elektrisch leitenden Wanne (2) befindet, oder bis zu einer Tiefe T im wesentlichen konstant oder wellenförmig und gemittelt über die Wellen annähernd konstant ist, wobei T > 0.

2. Vertikaler Hallsensor nach Anspruch 1, **dadurch gekennzeichnet, dass** die Dotierung des Dotierungsprofils zwischen der planaren Oberfläche (5) der elektrisch leitenden Wanne (2) und der Tiefe T in den Bereichen zwischen den Kontakten (4) geringer ist als in den Bereichen unterhalb der Kontakte (4).

3. Vertikaler Hallsensor nach Anspruch 1 oder 2, **dadurch gekennzeichnet, dass** das Dotierungsprofil in den Bereichen unterhalb der Kontakte (4) bis zur Tiefe T annähernd konstant ist, so dass die elektrische Leitfähigkeit in den genannten Bereichen grösser ist als in den Bereichen zwischen den Kontakten (4).

4. Verfahren zur Herstellung eines vertikalen Hallsensors in einem Halbleiterchip (1), der eine elektrisch leitende Wanne (2) eines ersten Leitfähigkeitstyps, die in ein elektrisch leitendes Gebiet (3) eines zweiten Leitfähigkeitstyps eingebettet ist und eine planare Oberfläche (5) aufweist, die parallel zu einer für die Verdrahtung zugänglichen Oberfläche des Halbleiterchips (1) verläuft, und elektrische Kontakte (4) aufweist, die dazu dienen, einen Strom durch den vertikalen Hallsensor fliessen zu lassen und eine Hallspannung abzugreifen, und die in die planare Oberfläche (5) der elektrisch leitenden Wanne (2) eingebettet und entlang einer Geraden (6) angeordnet sind, **dadurch gekennzeichnet, dass** die Herstellung der elektrisch leitenden Wanne (2) folgende Schritte umfasst:
- Implantieren von Fremdatomen eines ersten chemischen Elementes in das elektrisch leitende Gebiet (3) des zweiten Leitfähigkeitstyps mittels einer hochenergetischen Ionenimplantation, um ein Dotierungsprofil der Fremdatome zu erzeugen, das entweder ein Maximum hat, welches sich in einer Tiefe T₁ₐ von der planaren Oberfläche (5) der elektrisch leitenden Wanne (2) befindet, wobei T₁ₐ > 0, oder bis zu einer Tiefe T₂ₐ von der planaren Oberfläche (5) der elektrisch leitenden Wanne (2) mehrere Maxima aufweist oder annähernd konstant ist, wobei T₂ₐ > 0, und
- elektrisches Aktivieren der implantierten Fremdatome durch eine Erwärmung derart, dass das erzeugte Dotierungsprofil entweder ein Maximum hat, das in einer Tiefe T₁ ≅ T₁ₐ liegt, oder bis zu einer Tiefe T₂ ≥ T₂ₐ im wesentlichen konstant oder wellenförmig und gemittelt über die Wellen annähernd konstant ist.

5. Verfahren nach Anspruch 4, **gekennzeichnet durch** den zusätzlichen Schritt:
Implantieren von Fremdatomen eines zweiten chemischen Elementes in dem von der elektrisch leitenden Wanne (2) belegten Gebiet, um die Dotierung und somit die elektrische Leitfähigkeit unmittelbar unterhalb der planaren Oberfläche (5) zumindest in den Gebieten zwischen den Kontakten (4) zu reduzieren.

6. Verfahren nach Anspruch 4 oder 5, **gekennzeichnet durch** den zusätzlichen Schritt:
Implantieren von Fremdatomen des ersten chemischen Elementes oder eines dritten chemischen Elementes in den von den Kontakten (4) belegten Gebieten, um die Dotierung und somit die elektrische Leitfähigkeit unterhalb der Kontakte (4) zu erhöhen.

7. Verfahren nach einem der Ansprüche 4 bis 6, **dadurch gekennzeichnet, dass** die Erwärmung zum elektrischen Aktivieren der implantierten Fremdatome ein "Rapid Thermal Annealing" ist.

## Claims

1. Vertical Hall sensor, which is integrated in a semiconductor chip (1), with an electrically conductive well (2) of a first conductivity type, which is embedded in an electrically conductive region (3) of a second conductivity type, and with electrical contacts (4) which serve for making a current flow through the vertical Hall sensor and for tapping a Hall voltage and which are arranged along a straight line (6) on a planar surface (5) of the electrically conductive well (2), which extends parallel to a surface of the semiconductor chip (1) accessible for wiring, the electrically conductive well (2) having a doping profile generated by ion implantation and not by an epitaxy process and electrically isolated laterally and at the bottom from said electrically conductive region (3) by a pn junction, **characterized in that** the doping profile either has a maximum which is located at a depth T from the planar surface (5) of the electrically conductive well (2), or is essentially constant or is wavy and is approximately constant averaged over the waves up to a depth T, with T > 0.

2. Vertical Hall sensor according to claim 1, **characterized in that** the doping of the doping profile is less between the planar surface (5) of the electrically conductive well (2) and the depth T in the areas between the contacts (4) than in the areas below the contacts (4).

3. Vertical Hall sensor according to claim 1 or 2, **characterized in that** the doping profile is approximately constant in the areas below the contacts (4) up to the depth T, so that the electrical conductivity in the mentioned areas is greater than in the areas between the contacts (4).

4. Method for producing a vertical Hall sensor in a semiconductor chip (1), which has an electrically conductive well (2) of a first conductivity type, which is embedded in an electrically conductive region (3) of a second conductivity type and has a planar surface (5) extending parallel to a surface of the semiconductor chip (1) accessible for wiring, and which has electrical contacts (4) which serve for making a current flow through the vertical Hall sensor and for tapping a Hall voltage and which are embedded in the planar surface (5) of the electrically conductive well (2) and arranged along a straight line (6), **characterized in that** the production of the electrically conductive well (2) comprises the following steps:
- implanting foreign atoms of a first chemical element in the electrically conductive region (3) of the second conductivity type by means of a high-energy ion implantation in order to generate a doping profile of the foreign atoms which either has a maximum which is located at a depth T₁ₐ from the planar surface (5) of the electrically conductive well (2), with T₁ₐ > 0, or has multiple maxima or is approximately constant up to a depth T₂ₐ from the planar surface (5) of the electrically conductive well (2), with T₂ₐ > 0, and
- electrically activating the implanted foreign atoms by heating in such a manner that the generated doping profile either has a maximum which is at a depth T₁ ≅ T₁ₐ, or is essentially constant or is wavy and approximately constant averaged over the waves up to a depth T₂ ≥ T₂ₐ.

5. Method according to claim 4, **characterized by** the following additional step:
implanting foreign atoms of a second chemical element in the region occupied by the electrically conductive well (2), in order to reduce the doping and therefore the electrical conductivity directly below the planar surface (5) at least in the areas between the contacts (4).

6. Method according to claim 4 or 5, **characterized by** the additional step:
implanting foreign atoms of the first chemical element or a third chemical element in the regions occupied by the contacts (4), in order to increase the doping and therefore the electrical conductivity below the contacts (4).

7. Method according to any of claims 4 to 6, **characterized in that** the heating for electrically activating the implanted foreign atoms is a "Rapid Thermal Annealing".

## Revendications

1. Capteur Hall vertical intégré dans une puce à semi-conducteur (1), avec un puits électriquement conducteur (2) d'un premier type de conductivité, qui est intégré dans une région électriquement conductrice (3) d'un deuxième type de conductivité, et avec des contacts électriques (4) qui servent à faire passer un courant à travers le capteur Hall vertical et à prélever une tension Hall et qui sont disposés le long d'une ligne droite (6) sur une surface plane (5) du puits électriquement conducteur (2), qui s'étend parallèlement à une surface de la puce à semi-conducteur (1) accessible pour le câblage, le puits électriquement conducteur (2) présentant un profil de dopage généré par implantation ionique et non par un procédé d'épitaxie et isolé électriquement latéralement et au fond de ladite région électriquement conductrice (3) par une jonction pn, **caractérisé en ce que** le profil de dopage soit présente un maximum qui est situé à une profondeur T de la surface plane (5) du puits électriquement conducteur (2), soit est essentiellement constant ou est ondulé et est approximativement constant en moyenne sur les ondes jusqu'à une profondeur T, avec T > 0.

2. Capteur Hall vertical selon la revendication 1, **caractérisé en ce que** le dopage du profil de dopage entre la surface plane (5) du puits électriquement conducteur (2) et la profondeur T est moindre dans les zones entre les contacts (4) que dans les zones en dessous des contacts (4).

3. Capteur Hall vertical selon la revendication 1 ou 2, **caractérisé en ce que** le profil de dopage est approximativement constant dans les zones situées sous les contacts (4) jusqu'à la profondeur T, pour que la conductivité électrique dans les zones mentionnées est plus forte que dans les zones situées entre les contacts (4).

4. Procédé de fabrication d'un capteur Hall vertical dans une puce à semi-conducteur (1), qui a un puits électriquement conducteur (2) d'un premier type de conductivité, qui est intégré dans une région électriquement conductrice (3) d'un deuxième type de conductivité et qui a une surface plane (5) s'étendant parallèlement à une surface de la puce à semi-conducteur (1) accessible pour le câblage, et qui a des contacts électriques (4) qui servent à faire passer un courant à travers le capteur Hall vertical et à prélever une tension Hall, et qui sont intégrés dans la surface plane (5) du puits électriquement conducteur (2) et disposés le long d'une ligne droite (6), **caractérisé en ce que** la fabrication du puits électriquement conducteur (2) comprend les étapes suivantes:
- implantation d'atomes étrangers d'un premier élément chimique dans la région électriquement conductrice (3) du deuxième type de conductivité au moyen d'une implantation ionique à haute énergie afin de générer un profil de dopage des atomes étrangers qui soit présente un maximum qui se trouve à une profondeur T₁ₐ de la surface plane (5) du puits électriquement conducteur (2), avec T₁ₐ > 0, soit présente des maxima multiples ou est approximativement constant jusqu'à une profondeur T₂ₐ de la surface plane (5) du puits électriquement conducteur (2), avec T₂ₐ > 0, et
- activation électrique des atomes étrangers implantés par chauffage de telle sorte que le profil de dopage généré soit présente un maximum qui est situé à une profondeur T₁ ≅ T₁ₐ, soit est essentiellement constant ou est ondulé et approximativement constant en moyenne sur les ondes jusqu'à une profondeur T₂ ≥ T₂ₐ.

5. Procédé selon la revendication 4, **caractérisée par** l'étape supplémentaire suivante:
implantation d'atomes étrangers d'un deuxième élément chimique dans la région occupée par le puits électriquement conducteur (2), afin de réduire le dopage et donc la conductivité électrique directement sous la surface plane (5) au moins dans les régions situées entre les contacts (4).

6. Procédé selon la revendication 4 ou 5, **caractérisée par** l'étape supplémentaire:
implantation d'atomes étrangers du premier élément chimique ou d'un troisième élément chimique dans les régions occupées par les contacts (4), afin d'augmenter le dopage et donc la conductivité électrique en dessous des contacts (4).

7. Procédé selon l'une des revendications 4 à 6, **caractérisée en ce que** le chauffage pour l'activation électrique des atomes étrangers implantés est un "recuit thermique rapide".
